Europäisches Patentamt

European Patent Office

Office européen des brevets

(11) Publication number: **0 236 676 B1**

(12) **EUROPEAN PATENT SPECIFICATION**

(45) Date of publication of patent specification: **22.07.92** (51) Int. Cl.5: **G11C 16/00, H01L 27/10**

(21) Application number: **87100310.9**

(22) Date of filing: **13.01.87**

(54) **Erasable programmable read only memory using floating gate field effect transistors.**

(30) Priority: **14.01.86 JP 5310/86**

(43) Date of publication of application:
**16.09.87 Bulletin 87/38**

(45) Publication of the grant of the patent:
**22.07.92 Bulletin 92/30**

(84) Designated Contracting States:
**DE FR GB**

(56) References cited:
**EP-A- 0 040 251**
**US-A- 4 258 466**
**US-A- 4 493 057**

**IEEE TRANSACTIONS ON ELECTRON DE-VICE, vol. ED-31, no. 10, October, 1984, New York, US HIROSHI NOZAWA et al. "Characteristics and reliabi- lity of the SEPR-OM cell." pages 1413-1419**

(73) Proprietor: **FUJITSU LIMITED**
**1015, Kamikodanaka Nakahara-ku**
**Kawasaki-shi Kanagawa 211(JP)**

(72) Inventor: **Sugatani, Shinji c/o Fujitsu Limited**
**Kosugi Fujitsu Building 1812-10**
**Shimonumabe**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

## Description

The present invention relates to erasable programmable read only memory (EPROM) using floating gate field effect transistors.

It is important to cut down on marginal space allowances in circuit patterns, in order to increase the packing density of device elements in an IC (integrated circuit). The self alignment technique is a method which can be effectively employed for cutting down the marginal space allowances required for photolithographic mask alignment processes for fabricating ICs.

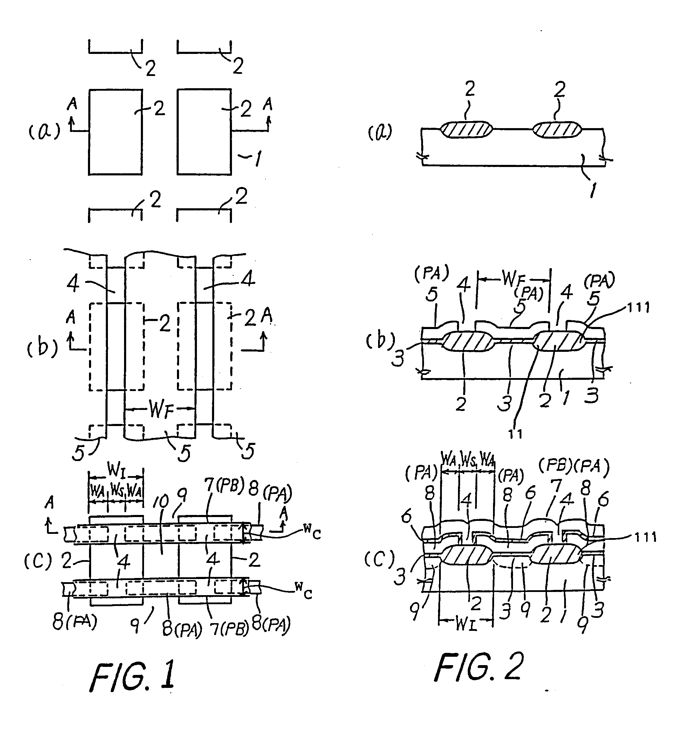

It has been proposed to apply the self alignment technique to an EPROM device composed of MOSFETs (metal-oxide-semiconductor type field effect transistors) having floating gates, to cut down the marginal space requirements on both sides of a gate (the sides between which the length of the gate of the FET is defined). However, it is still necessary to leave a margin for mask alignment in relation to processes which determine the width of a floating gate. This situation is explained briefly with reference to Figs. 1 and 2.

Fig. 1 gives plan views (a),(b),(c) schematically illustrating steps in the fabrication of an elementary memory cell of an EPROM device. Fig. 2 gives sectional views (a),(b),(c) taken along lines AA and seen in the direction indicated by arrows in the corresponding views (a),(b),(c) in Fig. 1.

As shown in Figs. 1(a) and 2(a), on a p-type silicon substrate 1, for example, a silicon dioxide ($SiO_2$) film is fabricated by selective oxidation and patterned to form a matrix of islands 2 on the substrate 1, for separating device elements from one another. The islands formed of the $SiO_2$ film provide field oxide layer islands.

Next, as shown in Figs. 1(b) and 2(b), the entire surface of the substrate is covered with a first gate oxide film 3 of $SiO_2$, formed by thermal oxidation. Subsequently, the surface is covered with a first conductive polysilicon layer (PA) 5. The first polysilicon layer 5 is patterned to form stripes separated from each other by grooves 4 which are formed by etching. Each of the grooves 4 is positioned to the centre of a column of field oxide layer islands 2, so field oxide layer islands are exposed at the centre part of the groove. A stripe of polysilicon, having a width $W_F$, bridges between adjacent columns of field oxide layer islands 2 as shown in Fig. 1(b) The width $W_F$ of the stripe later becomes the width of the floating gate of an FET. The direction of lines AA in Fig. 1 or the direction of the width $W_F$ in Fig. 2 will be referred to as the gate width direction, and the orthogonal direction, namely the direction of the arrows in Fig. 1, will be referred to as the gate length direction.

Subsequently, as shown in Figs. 1(c) and 2(c), the entire surface of the substrate is covered with a second gate oxide film 6, formed by thermal oxidation.

Next, the surface is covered with a second conductive polysilicon layer (PB) 7.

Then, the second gate oxide layer 6 and the stripes of the first polysilicon layer 5 are selectively etched off leaving second stripes orthogonal to the grooves 4. The second stripes have a predetermined width $W_C$ which later becomes the gate length of an FET.

By this etching process, portions of the first stripes 5 which are covered by the second stripes 7 become floating gates 8 of FETs, and the second stripes 7 become control gates which are extended in the gate width direction (the horizontal direction in the Figures) to become word lines. In such manner, floating gates 8 are formed underneath control gates 7 separated from the latter by second gate oxide film 6. The width and length of a floating gate 8 are respectively $W_F$ and $W_C$.

The surface of the p-type silicon substrate 1 where not covered by a second stripe is then doped with n-type impurities, by ion implantation for example, to form $n^+$-type source 9 and drain 10 regions.

In Fig. 1(c) a floating gate 8 is shown by a broken line which gives it the appearance of being slightly narrower (shorter) than a control gate 7, in order to identify the floating gate. However, it will be understood from the above explanation that control gate and floating gate are self aligned to each other and have substantially the same width, because a floating gate 8 is etched using self alignment technique utilising a control gate 7 as mask. Therefore, there is no need to allow a marginal space for mask alignment between control gate and floating gate in the gate length direction. So, packing density of FETs in the gate length direction is increased to the limit determined by the resolution of the photolithography. However, in the orthogonal direction, the gate width direction, on the contrary, marginal space allowance is necessary.

The grooves 4 in Figs. 1 and 2 must be aligned to respective columns of field oxide layer islands 2. Since grooves 4 are formed by photolithographic etching, it is necessary, as indicated by Figs. 1(c) and 2(c), to allow a marginal space $W_A$ on both sides of a groove 4 having a width $W_S$. With present state-of-the-art photolithography, marginal spaces $W_A$ of approximately 0.3 to 0.5 $\mu$m are necessary on both sides of a groove having a width $W_S$ of 0.6 to 1 $\mu$m for example. Therefore, the packing density of FETs in the gate width direction cannot be increased to the limit determined by the resolution of the photolithography.

Another phenomenon serving to decrease packing density in the gate width direction is the presence of invalid spaces under both sides of a floating gate, in the width $W_F$ direction, as indicated in Fig. 2(b). These invalid spaces are identified by 111 in Fig. 2(b) and (c). They are known as "bird's beaks". They are inevitably formed on both sides (gate width direction) of the field oxide layer islands 2. Bird's beaks extend sometimes 1 $\mu$m on both sides of a field oxide layer island 2 , and contribute neither to the conductance of the FET nor the capacitance of the floating gate.

There is an increasing need to cut down marginal space allowances and to eliminate bird's beaks, for example in the field of large scale integrated EPROMs.

Recently, an attempt to cut down marginal space allowances required for mask alignment, using a self alignment technique, has been proposed by H.Nozawa et al in "CHARACTERISTICS AND RELIABILITY OF THE SEPROM CELL" in IEEE Trans. ED vol.ED31, No.10, Oct. 1984.

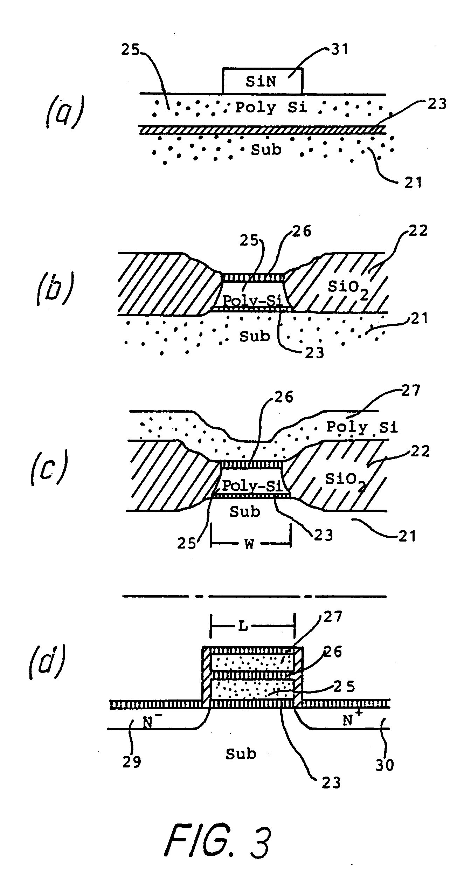

Schematic diagrams illustrating the fabrication process of this proposal are shown in Fig. 3.

A first gate oxide layer 23, a first conductive polysilicon layer 25 and a silicon nitride film 31 are successively formed on a substrate 21 and the silicon nitride film 31 patterned as shown in Fig. 3-(a). Then, as shown in Fig. 3(b), the first polysilicon layer 25 is oxidised to form field oxide layer 22 using silicon nitride film 31 as a mask. After removing silicon nitride film 31, a second gate oxide layer 26 is formed. Next, a second conductive polysilicon layer 27 is formed, as shown in Fig. 3(c). Then the substrate is etched in a similar manner to that illustrated in Fig. 1(c) and 2(c), and n-type impurity implanted to form n$^+$-type source 29 and drain 30. A cross-sectional view of the device, cut along a line from source to drain, is given in Fig. 3(d).

As described above, control gate 27 and floating gate 25 are self-aligned to each other. However, birds' beaks still occur. Also, as can be appreciated from the shape of Fig. 3(c), capacitance between floating gate and control gate is smaller than that between floating gate and channel region. This decreases control gate sensitivity and FET programming efficiency. Moreover, surface flatness of the device is not so good (not smooth). This can give rise to problems when forming wiring for interconnecting devices on the IC chip.

US-A-4 493 057 discloses an EPROM having a plurality of memory cell field effect transistors (FETs) arranged in a matrix on a semiconductor substrate, each memory cell FET comprising:-

a floating gate, for storing voltage thereon and controlling the conductivity of the memory cell FET;

a first gate insulation film, provided between the floating gate and the substrate for insulating the floating gate from the substrate;

a control gate positioned over the floating gate, for controlling the voltage of the floating gate;

a second insulation film provided between the floating gate and the control gate, for insulating the floating gate from the control gate; and

device separation regions provided on both sides of the floating gate in the gate width direction, for separating the memory cell FET from adjacent memory cell FETs on both those sides.

In this EPROM the device separation regions are formed on the substrate surface, by oxidation of the substrate. The floating gate and device separation regions are aligned side by side at the edges of the floating gate on its gate width sides.

According to the present invention, there is provided an erasable programmable read only memory (EPROM) having a plurality of memory cell field effect transistors (FETs) arranged in a matrix on a semiconductor substrate, each memory cell FET comprising:-

a floating gate formed of a first conductive layer, for storing voltage thereon and controlling the conductivity of the memory cell FET;

a first gate insulation film formed of a first insulation film, provided between the floating gate and the substrate for insulating the floating gate from the substrate;

a control gate positioned over the floating gate, for controlling the voltage of the floating gate;

a second insulation film provided between the floating gate and the control gate, for insulating the floating gate from the control gate; and

device separation regions provided on both sides of the floating gate in the gate width direction, for separating the memory cell FET from adjacent memory cell FETs on both those sides,

wherein said device separation regions are provided by grooves which penetrate through the first conductive layer and the first insulation film into the substrate and are filled with insulating material, the floating gate is positioned underneath the control gate, the width of the control gate being equal to the length of the floating gate, and the floating gate and device separation regions are aligned side by side at the edges of the floating gate on its gate width sides.

According to the present invention, there is also provided a process for fabricating an erasable programmable read only memory (EPROM) having a plurality of memory cell field effect transistors (FETs) arranged in a matrix on a semiconductor substrate, the process comprising:-

(a) Forming successively on a semiconductor substrate, having a first conductivity type, a first gate insulating film and a first conductive layer;

(b) Forming by photolithography a plurality of parallel device separation grooves extending in the gate length direction of the memory cell FETs to be fabricated, the spacing between the device separation grooves being equal to the gate width of the memory cell FETs to be fabricated, and the depth of the grooves being such that they penetrate through the first conductive layer and the first gate insulation film into the substrate;

(c) Forming a thick insulation layer to bury the device separation grooves;

(d) Removing parts of the thick insulation layer to expose the surface of the first conductive layer;

(e) Forming a second gate insulation film over the exposed surface of the first conductive layer and subsequently forming a second conductive layer thereover;

(f) Etching off the second conductive layer to leave parallel stripes of the material of that layer arranged orthogonally of the device separation grooves, the spacing between the stripes being equal to the spacing between the memory cell FETs to be fabricated, and the width of the stripes being equal to the floating gate length of the memory cell FETs to be fabricated, and then etching off successively the second gate insulating film, the first conductive layer and the first gate insulation film to expose the semiconductor substrate, using the parallel stripes as a mask; and

(g) Doping impurities, having conductivity type opposite to that of the semiconductor substrate, into the exposed semiconductor substrate to form source and drain regions of the memory cell FETs to be fabricated.

Embodiments of the present invention can provide EPROM devices having very high packing density of device elements, and can provide processes for fabricating such devices.

Embodiments of the present invention can provide a structure and a production process for an EPROM device which enables marginal space allowances on the IC chip to be cut down.

An embodiment of the present invention can provide a fabrication process for an EPROM device whose chip surface is smooth, so as to allow attainment of high reliability for interconnection wiring for device elements on the chip surface.

In an embodiment of the present invention a self-alignment technique is applied in relation to gate width and gate length directions to cut down on marginal space allowances for mask alignment. A floating gate is spaced at its periphery by separation grooves formed by etching, so that no birds' beaks appear. The grooves are filled, with silicon dioxide for example, to provide a smooth chip surface.

The etching processes in steps (b) and (f) are self aligned etching processes. Therefore, marginal space allowances for the lithography are unnecessary. Further, the memory cell FETs are separated by insulation layers buried in the separation grooves, so no bird's beaks appear.

The packing density of the memory cell FETs can thus be increased to the limit of photolithographic resolution.

Reference is made, by way of example, to the accompanying schematic drawings, in which:

Fig. 1 gives plan views (a),(b),(c) illustrating steps in the fabrication of an elementary memory cell of an EPROM device;

Fig. 2 gives sectional views (a),(b),(c) taken along lines AA and seen in the direction of the arrows in the corresponding views (a),(b),(c) of Flg. 1;

Fig. 3 gives sectional views (a) to (d) illustrating a process in which a self alignment technique is applied to the fabrication of a floating gate FET;

Fig. 4 gives sectional views (a) to (e) illustrating schematically steps in a fabrication process in accordance with an embodiment of the present invention; and

Fig. 5 gives a partial plan view (a) and a cross sectional view (b), taken along line BB and seen in the direction of the arrows in view (a), illustrating schematically the structure of an EPROM memory cell in an EPROM device embodying the present invention.

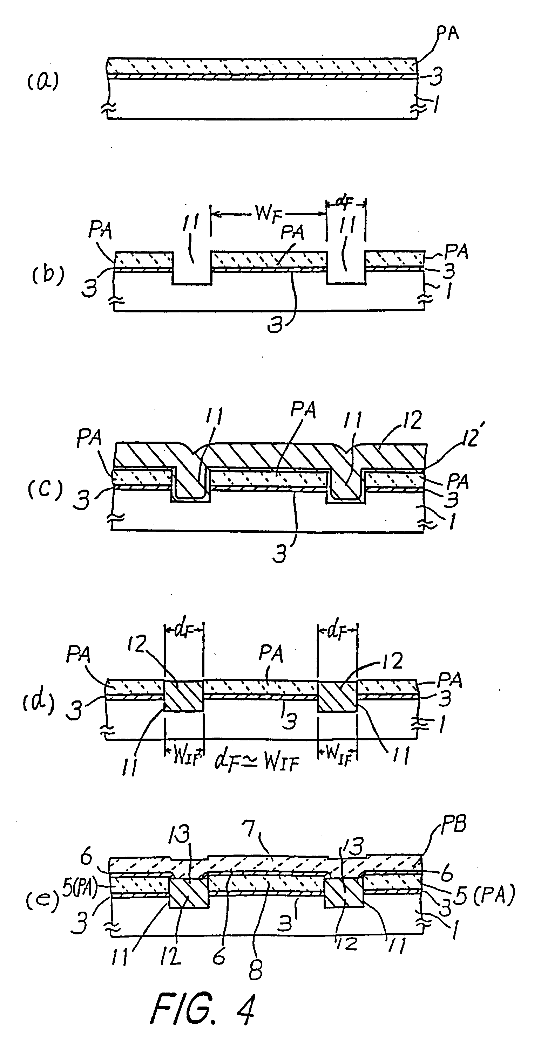

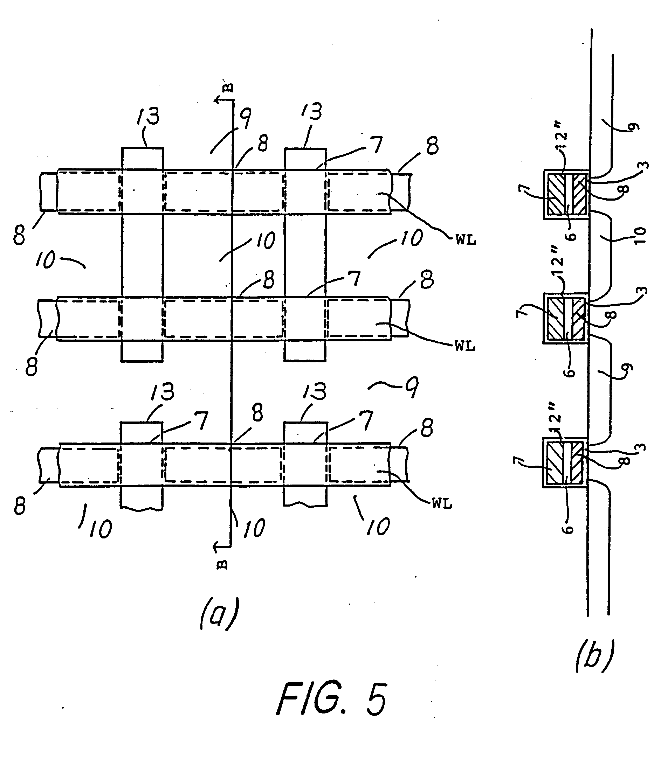

The configuration of an EPROM memory cell provided by an embodiment of the present invention and a fabrication process embodying the present invention will be described with reference to Figs. 4 and 5.

First, as shown in Fig. 4(a), a first gate oxide film 3 of silicon dioxide , having a thickness of 50 to 500 Angstroms, is formed by ordinary thermal oxidation on a p-type silicon substrate 1, having a resistivity of 10 to 20 Ohm cm for example. The entire surface of the substrate is then coated with a first conductive layer PA of polysilicon having a thickness of 3000 to 4000 Angstroms. This first polysilicon layer PA is formed by chemical vapour deposition (CVD), and is doped, with phosphorus or arsenic for example, so as to be conductive. The doping is carried out by conventional gas diffusion or ion implantation for example, during or after growth of the polysilicon PA.

Next, as shown in Fig. 4(b), the first polysilicon layer PA is grooved with a plurality of parallel device separation grooves 11. Each of the grooves has a width dF of 1μm and a depth of 0.6 μm for example. The depth of the grooves is not so critical. In the Figure, the grooves 11 penetrate through the first polysilicon layer PA and the first gate oxide film 3 and they reach to the substrate 1, penetrating it to a depth of 2000 to 4000 Angstroms. These grooves 11 are formed using a photolithographic mask and conventional reactive ion etching (RIE). The grooves 11 are separated from each other by a distance $W_F$ which later becomes the gate width of memory cell FETs. Though the distance $W_F$ appears rather large in the Figure, it corresponds to a gate width $W_F$ of 1 $\mu$m.

Then, as shown in Fig. 4(c), a silicon dioxide layer 12 0.5 to 1 $\mu$m thick is formed on the entire surface of the substrate. So, the grooves 11 are perfectly buried by $SiO_2$. Before forming the $SiO_2$ layer 12, it is desirable to cover the entire surface of the substrate by a thermal oxidized thin $SiO_2$ film 12' a few hundred Angstroms thick. This $SiO_2$ film 12' protects edges of parts of the polysilicon layer PA, which later become memory cell FET floating gates, from contamination which might be included in the CVD grown thick $SiO_2$ layer 12, and prevents leakage current. However, since the thin $SiO_2$ layer 12' and the thick $SiO_2$ layer 12 are both silicon dioxide, and they cannot be distinguished from each other, in the following Figures separate indication of the thin $SiO_2$ film 12' is omitted.

Next, as shown in Fig. 4(d), the surface of the substrate is polished until the surface of the polysilicon layer PA is exposed. The polishing may be mechanical, but it is preferred to use reactive ion etching (RIE) using fluoroform ($CHF_3$) as an etchant gas to etch off the $SiO_2$ layer 12 to provide a flat etched surface. It is easy to stop the polishing or etching of the substrate, watching the surface for exposure of the first polysilicon layer PA. If RIE as described above is applied, $SiO_2$ is etched faster than the polysilicon so, precisely speaking, the surface of the buried $SiO_2$ 12 is slightly over-etched with respect to the surface of the first polysilicon layer PA, as can be seen in Fig. 4(d). However, the level difference between the surface of the first polysilicon layer PA and $SiO_2$ 12 in the groove is negligibly small, so a flat surface is obtained.

Later, $SiO_2$ 12 in a groove 11 becomes a device separation region 13 buried in the substrate, and the width dF of the buried $SiO_2$ 12 becomes the device separation width $W_{IF}$ between memory cell FETs. It will be noted that the photolithographic mask is used only once in the step of Fig. 4(b), and the device separation regions are formed by self alignment, therefore, the device separation width $W_{IF}$ is equal to dF the width of the groove 11. There is no marginal space allowance for mask alignment on the two sides of the gate width $W_F$. Further, since the separation regions 13 are formed by etching, there appear no bird's beaks.

Next, as shown in Fig. 4(e), the surface of the first polysilicon layer PA is covered with second gate oxide film 6, 300 to 500 Angstroms thick, fabricated by thermal oxidation. Then, over the entire surface of the substrate, a second polysilicon layer PB, 4000 to 4500 Angstroms thick is formed. The second polysilicon layer PB is deposited by CVD, and is doped with phosphorus or arsenic during or after its growth, by gas diffusion or ion implantation for example.

Then, the second polysilicon layer PB is patterned by photolithography to form parallel stripes oriented orthogonally with respect to the device separation grooves 11. The width of a stripe later becomes the gate length of a memory cell FET, and the spacing between the stripes becomes the spacing between memory cells in the gate length direction. For example, the width of a stripe is 1 $\mu$m, and the spacing between stripes is 1.2 to 1.5 $\mu$m. Each of the stripes becomes a control gate electrode 7 which extends on both sides of the Figure to form a word line WL as shown in Fig. 5. Utilising this control gate electrode 7 as a mask, the second gate oxide film 6, first polysilicon layer PA and first gate oxide film 3 are etched off successively to expose the surface of the p-type silicon substrate.

By this etching process, floating gates 8 of the memory cell FETs are formed underneath the gate electrodes 7. The floating gates 8 are insulated from the substrate 1 and the gate electrode 7 respectively by the first and second gate oxide films 3 and 6. It will be understood that the floating gates 8 and the control gates 7 are self aligned, so there is no marginal space allowance for photolithography in the gate length direction. Further there appear no bird's beaks since the device separation regions 13 are formed by etching. Thus, marginal space allowances and the occurrence of bird's beaks in both gate length and gate width directions are cut down.

At this stage, it is desirable, as shown in Fig 5-(b), to form a thin $SiO_2$ film 12'', a few hundred Angstroms thick, on both sides of the floating gates 8 and the control gates 7 to protect them from contamination. Fig. 5(b) is a cross sectional view of the device of Fig. 5(a) taken along line BB and seen in the direction of the arrows.

$n^+$-type impurities such as arsenic for example, are doped into the exposed surface of the substrate 1 to form sources 9 and drains 10 as shown in Fig. 5. The doping may be effected by ordinary means such as diffusion or ion implantation. If it is effected by a diffusion process, the thin $SiO_2$ film 12'' on the surface of the substrate should be removed beforehand. It may be left in place if the doping is effected by ion implantation.

As can be seen in Fig. 5, device separation regions 13 are not extended continuously in the gate length direction, but are interrupted at source regions 9. This is a modification of the above described processes and is provided due to the fact that, in EPROM devices, the source regions should be connected to each other in the direction of a word line WL. It will be readily understood that such interruption of the device separation regions can be effected by interrupting the device separation grooves 11 at the stage of Fig. 4(b). By providing such interruptions of regions 13, interconnection wiring for connecting sources is saved.

In such manner, the main parts of EPROM memory cell FETs are fabricated. Subsequently, the FETs are interconnected on the surface of the substrate. Though it is not shown in the Figures, the surface of the device is coated with a passivation layer of phosphosilicate glass (PSG) for example, and contact windows are opened to contact to the drains 10, for example. Then, interconnection wiring, such as bit lines for example, is provided through these contact windows, and the device is completed.

Applying an embodiment of the present invention to an EPROM device, the packing density of memory cells has been increased by 30% as compared with that of a previously proposed device.

In the above description reference is made to a p-type silicon substrate. It will be clear, however, that embodiments of the present invention can be applied to n-type substrates merely by varying the conductivity types of impurity materials. The first and second polysilicon layers PA and PB may be replaced by other kinds of conductive material, such as metal silicide. The semiconductor material used is not limited to silicon. Embodiments of the present invention may be applied to other kinds semiconductor materials, such as gallium arsenide for example.

For an EPROM having floating gate type FET memory cells, required marginal space allowances for mask alignment, and the incidence of bird's beaks, are cut down by applying self alignment techniques to determine both gate width and gate length.

On a substrate (1), a first gate insulation film (3) and a first conductive (e.g. polysilicon) layer (PA) are formed. Parallel grooves (11) for device separation are formed in the gate length direction by photolithography. The space between the grooves (11) defines gate width: the width of the grooves determines spacing between the cell FETs. The grooves are buried by insulator (e.g. $SiO_2$) (12) deposited by chemical vapour deposition. Then etching is used to expose the first conductive layer (PA), and a second gate insulation film (6) and a second conductive (e.g. polysilicon) layer (PB) are formed on the exposed surface. Parallel stripes (7) are formed, by etching the second conductive layer, orthogonal to the grooves (11). The spacing between the stripes determines device separation in the gate length direction. The stripes are then used as the mask for etching to expose the substrate (1) in which sources (9) and drains (10) are then formed by doping.

## Claims

1. An erasable programmable read only memory (EPROM) having a plurality of memory cell field effect transistors (FETs) arranged in a matrix on a semiconductor substrate (1), each memory cell FET comprising:

   a floating gate (8), formed of a first conductive layer, for storing voltage thereon and controlling the conductivity of the memory cell FET;

   a first gate insulation film (3) formed of a first insulation film, provided between the floating gate and the substrate for insulating the floating gate from the substrate;

   a control gate (7) positioned over the floating gate, for controlling the voltage of the floating gate;

   a second insulation film (6) provided between the floating gate and the control gate, for insulating the floating gate from the control gate; and

   device separation regions (13) provided on both sides of the floating gate in the gate width direction, for separating the memory cell FET from adjacent memory cell FETs an both those sides,

   characterized in that
   said device separation regions (13) are provided by grooves (11) which penetrate through the first conductive layer and the first insulation film into the substrate and are filled with insulating material, the floating gate is positioned underneath the control gate, the width of the control gate being equal to the length of the floating gate, and the floating gate and device separation regions being aligned side by side at the edges of the floating gate on its gate width sides.

2. An EPROM as claimed in claim 1, wherein each memory cell FET further comprises a thin insulation film (12") covering side edges of the floating gate (8) and the control gate (7).

3. An EPROM as claimed in claim 1 or 2, wherein the floating gate (8) and the control gate (7) are of polysilicon.

4. An EPROM as claimed in claim 1, 2 or 3, wherein the substrate (1) is of silicon, the first gate insulation film (3), the second gate insulation film (6), and the thin insulation film (12")

are of silicon dioxide.

5. An EPROM as claimed in claim 1 or 2, wherein the floating gate (8) and the control gate (7) are of metal silicide.

6. A process for fabricating an erasable programmable read only memory (EPROM) having a plurality of memory cell field effect transistors (FETs) arranged in a matrix on a semiconductor substrate, the process comprising:

   (a) forming successively on a semiconductor substrate (1), having a first conductivity type, a first gate insulating film (3) and a first conductive layer (PA,5);

   (b) forming by photolithography a plurality of parallel device separation grooves (11) extending in the gate length direction of the memory cell FETs to be fabricated, the spacing between the device separation grooves (11) being equal to the gate width of the memory cell FETs to be fabricated, and the depth of the grooves (11) being such that they penetrate through the first conductive layer and the first gate insulation film into the substrate (1);

   (c) forming a thick insulation layer (12) to bury the device separation grooves;

   (d) removing parts of the thick insulation layer to expose the surface of the first conductive layer;

   (e) forming a second gate insulation film (6) over the exposed surface of the first conductive layer and subsequently forming a second conductive layer (PB,7) thereover;

   (f) etching off the second conductive layer to leave parallel stripes (7) of the material of that layer arranged orthogonally of the device separation grooves, the spacing between the stripes being equal to the spacing between the memory cell FETs to be fabricated, and the width of the stripes being equal to the floating gate length of the memory cell FETs to be fabricated, and then etching off successively the second gate insulating film, the first conductive layer and the first gate insulation film to expose the semiconductor substrate, using the parallel stripes (7) as a mask; and

   (g) doping impurities, having conductivity type opposite to that of the semiconductor substrate, into the exposed semiconductor substrate to form source (9) and drain regions (10) of the memory cell FETs to be fabricated.

7. A process as claimed in claim 6, further comprising:

   (b$'$) between steps (b) and (c), forming a thin insulation film (12$'$) over the surface exposed at the conclusion of step (b);

   (f$'$) between steps (f) and (g), forming a thin insulation film (12$''$) over the surface exposed at the conclusion of step (f).

8. A process as claimed in claim 6 or 7, wherein the substrate (1) is of silicon, and the first gate insulation film (3) and the second gate insulation film (6), and the thin insulation films (12$'$,12$''$) where provided, are of silicon dioxide, formed by thermal oxidation.

9. A process as claimed in claim 6, 7 or 8, wherein the first (PA,5) and second (PB,7) conductive layers are of polysilicon formed by chemical vapour deposition.

10. A process as claimed in claim 6, 7, 8 or 9, wherein step (d) is accomplished by reactive ion etching.

11. A process as claimed in claim 6, 7, 8 or 9, wherein step (d) is accomplished by mechanical polishing.

12. A process as claimed in claim 6, 7, 8, 9 or 10, wherein the etching processes employed in steps (b) and (f) are reactive ion etching processes.

13. A process as claimed in any one of claims 6 to 12, wherein step (c) is a chemical vapour deposition process and the thick insulation layer is a silicon dioxide layer.

**Revendications**

1. Mémoire morte programmable effaçable (EPROM) comportant une pluralité de transistors à effet de champ (FET) de cellule de mémoire agencés selon une matrice sur un substrat semiconducteur (1), chaque FET de cellule de mémoire comprenant :

   une grille flottante (8) constituée par une première couche conductrice pour stocker une tension dessus et pour commander la conductivité du FET de cellule de mémoire ;

   un premier film d'isolation de grille (3) constitué par un premier film d'isolation prévu entre la grille flottante et le substrat pour isoler la grille flottante du substrat ;

   une grille de commande (7) positionnée sur la grille flottante pour commander la tension de la grille flottante ;

   un second film isolant (6) prévu entre la grille flottante et la grille de commande pour isoler la grille flottante de la grille de commande ; et

des régions de séparation de dispositifs (13) prévues sur les deux côtés des grilles flottantes suivant la direction de largeur de grille pour séparer le FET de cellule de mémoire de FET de cellule de mémoire adjacents sur ces deux côtés,

caractérisée en ce que lesdites régions de séparation de dispositifs (13) sont munies de gorges (11) qui pénètrent au travers de la première couche conductrice et du premier film d'isolation à l'intérieur du substrat et qui sont remplies d'un matériau isolant,

la grille flottante est positionnée au-dessous de la grille de commande, la largeur de la grille de commande étant égale à la longueur de la grille flottante et la grille flottante ainsi que les régions de séparation de dispositifs étant alignées côte-à-côte au niveau des bords de la grille flottante sur ses côtés de largeur de grille.

2. EPROM selon la revendication 1, dans laquelle chaque FET de cellule de mémoire comprend en outre un film mince d'isolation (12") qui recouvre des bords latéraux de la grille flottante (8) et de la grille de commande (7).

3. EPROM selon la revendication 1 ou 2, dans laquelle la grille flottante (8) et la grille de commande (7) sont en polysilicium.

4. EPROM selon l'une des revendications 1, 2 ou 3, dans laquelle le substrat (1) est en silicium, le premier film d'isolation de grille (3), le second film d'isolation de grille (6) et le film mince d'isolation (12") sont en dioxyde de silicium.

5. EPROM selon la revendication 1 ou 2, dans laquelle la grille flottante (8) et la grille de commande (7) sont en siliciure de métal.

6. Procédé de fabrication d'une mémoire morte programmable effaçable (EPROM) comportant une pluralité de transistors à effet de champ (FET) de cellule de mémoire agencés selon une matrice sur un substrat semiconducteur, le procédé comprenant :

(a) la formation successive sur un substrat semiconducteur (1) qui présente un premier type de conductivité d'un premier film d'isolation de grille (3) et d'une première couche conductrice (PA, 5) ;

(b) la formation par photolithographie d'une pluralité de gorges parallèles de séparation de dispositifs (11) s'étendant suivant la direction de longueur de grille des FET de cellule de mémoire qui doivent être fabriqués, l'espacement entre les gorges de séparation de dispositifs (11) étant égal à la largeur de grille des FET de cellule de mémoire qui doivent être fabriqués et la profondeur des gorges (11) étant telle qu'elles pénètrent au travers de la première couche conductrice et du premier film d'isolation de grille à l'intérieur du substrat (1) ;

(c) la formation d'une couche d'isolation épaisse (12) pour enterrer les gorges de séparation de dispositifs ;

(d) l'enlèvement de parties de la couche d'isolation épaisse pour exposer la surface de la première couche conductrice ;

(e) la formation d'un second film d'isolation de grille (6) sur la surface exposée de la première couche conductrice puis la formation d'une seconde couche conductrice (PB, 7) dessus ;

(f) l'enlèvement par gravure de la seconde couche conductrice pour laisser des bandes parallèles (7) du matériau de cette couche agencées perpendiculairement aux gorges de séparation de dispositifs, l'espacement entre les bandes étant égal à l'espacement entre les FET de cellule de mémoire qui doivent être fabriqués, et la largeur des bandes étant égale à la longueur de grille flottante des FET de cellule de mémoire qui doivent être fabriqués, puis l'enlèvement par gravure successivement du second film d'isolation de grille, de la première couche conductrice et du premier film d'isolation de grille afin d'exposer le substrat semiconducteur en utilisant les bandes parallèles (7) en tant que masque ; et

(g) le dopage d'impuretés qui présentent un type de conductivité opposé à celui du substrat semiconducteur à l'intérieur du substrat semiconducteur exposé pour former des régions de source (9) et de drain (10) des FET de cellule de mémoire qui doivent être fabriqués.

7. Procédé selon la revendication 6, comprenant en outre :

(b') entre les étapes (b) et (c), la formation d'un film mince d'isolation (12') sur la surface exposée à la fin de l'étape (b) ; et

(f') entre les étapes (f) et (g), la formation d'un film mince d'isolation (12") sur la surface exposée à la fin de l'étape (f).

8. Procédé selon la revendication 6 ou 7, dans lequel le substrat (1) est en silicium et le premier film d'isolation de grille (3) et le second film d'isolation de grille (6) ainsi que les films minces d'isolation (12', 12"), où ils sont prévus, sont en dioxyde de silicium et sont formés par oxydation thermique.

9. Procédé selon la revendication 6, 7 ou 8, dans lequel les première (PA, 5) et seconde (PB, 7) couches conductrices sont en polysilicium et sont formées par dépôt chimique en phase vapeur.

10. Procédé selon la revendication 6, 7, 8 ou 9, dans lequel l'étape (d) est réalisée par gravure ionique réactive.

11. Procédé selon la revendication 6, 7, 8, ou 9, dans lequel l'étape (d) est réalisée par polissage mécanique.

12. Procédé selon la revendication 6, 7, 8, 9 ou 10, dans lequel les procédés de gravure utilisés lors des étapes (b) et (f) sont des procédés de gravure ionique réactive.

13. Procédé selon l'une quelconque des revendications 6 à 12, dans lequel l'étape (c) est un procédé de dépôt chimique en phase vapeur et la couche d'isolation épaisse est une couche en dioxyde de silicium.

**Patentansprüche**

1. Ein löschbarer programmierbarer Nur-Lese-Speicher (EPROM) mit einer Vielzahl von matrixförmig auf einem Halbleitersubstrat (1) angeordneten Speicherzellen-Feldeffekttransistoren (FETs), wobei jeder Speicherzellen-FET umfaßt:

ein aus einer ersten leitenden Schicht gebildetes schwimmendes Gate (8) zum Speichern von Spannung darauf und zum Steuern der Leitfähigkeit des Speicherzellen-FETs;

einen ersten, aus einem ersten Isolierfilm gebildeten Gate-Isolierfilm (3), der zwischen dem schwimmenden Gate und dem Substrat zum Isolieren des schwimmenden Gates von dem Substrat vorgesehen ist;

ein über dem schwimmenden Gate positioniertes Steuergate (7) zum Steuern der Spannung des schwimmenden Gates;

einen zweiten, zwischen dem schwimmenden Gate und dem Steuergate vorgesehenen Isolierfilm (6) zum Isolieren des schwimmenden Gates vom Steuergate; und

Anordnungstrennungsbereiche (13), die auf beiden Seiten des schwimmenden Gates in Gate-Breitenrichtung vorgesehen sind, für das Trennen des Speicherzellen-FETs von den benachbarten Speicherzellen-FETs auf jenen beiden Seiten,

dadurch gekennzeichnet, daß die genannten Anordnungstrennungsbereiche (13) durch Nuten (11) gebildet sind, welche durch die erste leitende Schicht und den ersten Isolierfilm in das Substrat dringen und mit Isolierstoff gefüllt sind, daß das schwimmende Gate unter dem Steuergate positioniert ist, wobei die Breite des Steuergates gleich der Länge des schwimmenden Gates ist und das schwimmende Gate und die Anordnungstrennungsbereiche Seite an Seite an den Kanten des schwimmenden Gates an seinen Gate-Breitseiten angeordnet sind.

2. Ein EPROM nach Anspruch 1, bei dem jeder Speicherzellen-FET ferner einen dünnen Isolierfilm (12") umfaßt, welcher die Seitenkanten des schwimmenden Gates (8) und des Steuergates (7) bedeckt.

3. Ein EPROM nach Anspruch 1 oder 2, bei dem das schwimmende Gate (8) und das Steuergate (7) aus Polysilizium bestehen.

4. Ein EPROM nach Anspruch 1, 2 oder 3, bei dem das Substrat (1) aus Silizium, der erste Gate-Isolierfilm (3), der zweite Gate-Isolierfilm (6) und der dünne Isolierfilm (12") aus Siliziumdioxid bestehen.

5. Ein EPROM nach Anspruch 1 oder 2, bei dem das schwimmende Gate (8) und das Steuergate (7) aus Metallsilizid bestehen.

6. Ein Verfahren zum Herstellen eines löschbaren programmierbaren Nur-Lese-Speichers (EPROM) mit einer Vielzahl von matrixförmig auf einem Halbleitersubstrat angeordneten Speicherzellen-Feldeffekttransistoren (FETs), welches Verfahren umfaßt:

(a) Bilden eines ersten Gate-Isolierfilms (3) und einer ersten leitenden Schicht (PA, 5) nacheinander auf einem Halbleitersubstrat (1) von einem ersten Leitfähigkeitstyp;

(b) Bilden, durch Fotolithografie, einer Vielzahl von parallelen Anordnungstrennungsnuten (11), welche sich in Gate-Längsrichtung der herzustellenden Speicherzellen-FETs erstrecken, wobei der Abstand zwischen den Anordnungstrennungsnuten (11) gleich der Gatebreite der herzustellenden Speicherzellen-FETs ist, und die Tiefe der Nuten (11) so ist, daß sie durch die erste leitende Schicht und den ersten Gate-Isolierfilm in das Substrat (1) dringen;

(c) Bilden einer dicken Isolierschicht (12) zum Begraben der Anordnungstrennungsnuten;

(d) Entfernen von Teilen der dicken Isolierschicht zum Freilegen der Oberfläche der ersten leitenden Schicht;

(e) Bilden eines zweiten Gate-Isolierfilms (6) über der freigelegten Oberfläche der ersten leitenden Schicht und nachfolgend Bilden einer zweiten leitenden Schicht (PB, 7) darüber;

(f) Abätzen der zweiten leitenden Schicht, um parallele Streifen (7) des Materials jener Schicht zu hinterlassen, welche orthogonal von den Anordnungstrennungsnuten angeordnet sind, wobei der Abstand zwischen den Streifen gleich dem Abstand zwischen den herzustellenden Speicherzellen-FETs ist, und die Breite der Streifen gleich der Länge des schwimmenden Gates der herzustellenden Speicherzellen-FETs ist, und danach sukzessives Abätzen des zweiten Gate-Isolierfilms, der ersten leitenden Schicht und des ersten Gate-Isolierfilms, um das Halbleitersubstrat freizulegen, unter Verwendung der parallelen Streifen (7) als Maske; und

(g) Dotieren von Verunreinigungen, welche den entgegengesetzten Leitfähigkeitstyp zu jenem des Halbleitersubstrats haben, in das freigelegte Halbleitersubstrat, um Source- (9) und Drainbereiche (10) der herzustellenen Speicherzellen-FETs zu bilden.

7. Ein Verfahren nach Anspruch 6, welches ferner umfaßt:

(b') zwischen den Schritten (b) und (c), Bilden eines dünnen Isolierfilms (12') über der beim Abschluß des Schrittes (b) freigelegten Oberfläche;

(f') zwischen den Schritten (f) und (g), Bilden eines dünnen Isolierfilms (12") über der beim Abschluß des Schrittes (f) freigelegten Oberfläche.

8. Ein Verfahren nach Anspruch 6 oder 7, bei welchem das Substrat (1) aus Silizium besteht, und der erste Gate-Isolierfilm (3) und der zweite Gate-Isolierfilm (6) und die dünnen Isolierfilme (12', 12"), wo vorgesehen, aus Siliziumdioxid, welches durch thermische Oxidation gebildet wird, bestehen.

9. Ein Verfahren nach Anspruch 6, 7 oder 8, bei welchem die ersten (PA, 5) und zweiten (PB, 7) leitenden Schichten aus Polysilizium bestehen, welches durch chemische Dampfabscheidung gebildet wird.

10. Ein Verfahren nach Anspruch 6, 7, 8 oder 9, bei welchem Schritt (d) durch reaktive Ionenätzung realisiert wird.

11. Ein Verfahren nach Anspruch 6, 7, 8, oder 9, bei welchem Schritt (d) durch mechanisches Polieren realisiert wird.

12. Ein Verfahren nach Anspruch 6, 7, 8, 9 oder 10, bei welchem die in den Schritten (b) und (f) angewandten Ätzverfahren reaktive Ionenätzverfahren sind.

13. Ein Verfahren nach irgendeinem der Ansprüche 6 bis 12, bei welchem Schritt (c) ein chemisches Dampfabscheidungsverfahren und die dicke Isolierschicht eine Siliziumdioxidschicht sind.

EP 0 236 676 B1

FIG. 1

FIG. 2

11

FIG. 3

FIG. 4

FIG. 5